# EUROPÄISCHE PATENTSCHRIFT

(11) **EP 0 402 798 B1**
(45) Veröffentlichungstag und Bekanntmachung des Hinweises auf die Patenterteilung: **03.05.1995**
(21) Anmeldenummer: 90110923.1
(22) Anmeldetag: 09.06.1990
(51) Int. Cl.: C23C 16/48

(54) **Beschichtungsvorrichtung**
Coating device
Dispositif de revêtement

(30) Priorität: 15.06.1989 DE 3919538
(43) Veröffentlichungstag der Anmeldung: 19.12.1990
(73) Patentinhaber: Heraeus Noblelight GmbH, D-63801 Kleinostheim (DE)
(72) Erfinder: Esrom, Hilmar, Dr., D-6803 Edingen-Neckarhausen (DE); Kogelschatz, Ulrich, Dr., D-5212 Hausen bei Brugg (DE)
(74) Vertreter: Kühn, Hans-Christian

(56) Entgegenhaltungen:
- EP-A- 0 310 347
- DE-A- 3 641 718
- US-A- 4 495 218

## Beschreibung

Die Erfindung bezieht sich auf eine Vorrichtung mit einer UV-Strahlungsquelle und einer Zuleitung für ein Prozeßgas zur Beschichtung von Substraten gemäß dem Oberbegriff des Patentanspruches 1.

Solche Vorrichtungen kommen bevorzugt bei Beschichtungsprozessen zum Einsatz, die durch photolytische Spaltung bewirkt werden. Solche Beschichtungen werden nicht nur zur Ausbildung von Halbleitern, sondern auch zur Veredelung von Oberflächen, insbesondere zur Härtung derselben, zur Bildung von Glanzschichten und zur Erzeugung von Kratzfestigkeit sowie zum Korrosionsschutz solcher Oberflächen verwendet. Bei den bisher bekannten Einrichtungen erfolgt die photolytische Spaltung unter Verwendung von UV-Strahlung, die in eine Beschichtungsapparatur eingestrahlt wird, in welcher die zu beschichtenden Substrate angeordnet sind. Von Nachteil ist bei diesen Beschichtungsapparaturen, daß es ohne zusätzliche Maßnahmen zu einer unmittelbaren Abscheidung des Beschichtungsmaterials auf der Innenseite des Fensters kommt, durch welches die UV-Strahlung in die Beschichtungsapparatur einfällt. Mit Hilfe aufwendiger Konstruktionen muß dieses Fenster mit Hilfe eines Gasvorhangs aus einem inerten Gas von dem Prozeßgas getrennt werden. Bei der Verwendung sehr kurzwelliger Strahlung mit einem Wellenlängenbereich von kleiner 200 nm ist die Auswahl des Fenstermaterials stark eingeschränkt. Zudem ist eine Abnahme der Transparenz bei dem Fenstermaterial bei intensiver UV-Strahlung festzustellen.

Der Erfindung liegt deshalb die Aufgabe zugrunde, eine Vorrichtung zu schaffen, bei der die Nachteile der bekannten Einrichtungen ausgeschlossen sind, und die eine leichte Beschichtung von Substraten ermöglicht.

Die Aufgabe wird dadurch gelöst, daß ein Reaktorbehälter vorgesehen ist, in dem die UV-Strahlungsquelle und das zu beschichtende Substrat gemeinsam angeordnet sind, wobei die Zuleitung für das Prozeßgas tangential zur Oberfläche des Substrates im Abstand von wenigstens 2 cm hiervon angeordnet ist, und daß wenigstens eine Zuleitung für ein Abschirmgas zwischen der UV-Strahlenquelle und der Zuleitung für das Prozeßgas vorgesehen ist, sowie mindestens eine Anleitung für die in den Reaktorbehälter eingeleiteten Gase vorgesehen sind.

Ein Vorteil der erfindungsgemäßen Vorrichtung liegt darin, daß die Abscheidungstemperatur sehr niedrig gehalten werden kann. Bei Anwendung der erfindungsgemäßen Vorrichtung kann die Beschichtung der Substrate bei Raumtemperatur durchgeführt werden. Durch die Verwendung von Helium, Krypton, Xenon oder Argon läßt sich mit der im Reaktorbehälter angeordneten Strahlungsquelle UV-Strahlung im Wellenlängenbereich von 90 nm, 150 nm oder 170 nm erzeugen. Für die Beschichtung kann das hierfür vorgesehene Material in einer gasförmigen Verbindung in den Reaktorbehälter eingeleitet werden. Andererseits besteht die Möglichkeit, auf das Substrat eine organische oder anorganische Verbindung aus einer Lösung oder in Pulverform aufzutragen und diese mit Hilfe der UV-Strahlung zu zersetzen, wobei sich der gewünschte Überzug auf dem Substrat ausbildet.

Die erfindungsgemäße Vorrichtung wird vorzugsweise als zylinderförmiger Reaktorbehälter ausgebildet, der verschließbar ist. Die UV-Strahlungsquelle besteht aus Elektroden, die als langgestreckte Hohlkörper ausgebildet sind. Vorzugsweise sind die Elektroden als Hohlzylinder geformt, die aus Glas oder Metall gefertigt sind. Die aus Metall gefertigten Elektroden weisen auf ihrer Oberfläche einen Überzug aus einem Dielektrikum auf. Die aus Glas gefertigten Elektroden sind innen mit einer Metallbeschichtung versehen. Die Elektroden sind so angeordnet, daß ihre Längsachsen parallel und in definiertem Abstand zueinander angeordnet sind, derart, daß zwischen je zwei benachbarten Elektroden ein Spalt ausgebildet wird. Diese Spalte weisen vorzugsweise eine Breite von 0,1 bis 10 mm auf. Die Elektroden selbst weisen wenigstens einen Durchmesser von 8 mm auf. Die UV-Strahlungsquelle ist innerhalb des Reaktorbehälters so angeordnet, daß ihr Abstand von der nach oben weisenden Deckfläche des Reaktorbehälters nur wenige Zentimeter beträgt. Die Elektroden sind mit ihren Längsachsen parallel zur Deckfläche des Reaktorbehälters angeordnet. In der Deckfläche des Reaktorbehälters ist die Zuleitung für ein die UV-Strahlung bildendes Gas vorgesehen. Durch Anlegen einer großen Wechselspannung an jeweils zwei benachbarte Elektroden und durch das Einleiten eines definierten Gases in die Spalte zwischen den Elektroden wird eine stille Entladung in den Spalten ausgebildet und dabei eine UV-Strahlung mit definierter Wellenlänge erzeugt. Das zu beschichtende Substrat wird auf dem Boden des Reaktorbehälters angeordnet. Das Prozeßgas, das eine gasförmige Verbindung des Beschichtungsmaterials ist oder enthält, wird tangential zu der zu beschichtenden Oberfläche des Substrats in definiertem Abstand davon in den Reaktorbehälter eingeleitet. Um die UV-Strahlungsquelle bzw. die von ihr erzeugte UV-Strahlung von Beeinträchtigungen durch das Prozeßgas abzuschirmen, wird zwischen der UV-Strahlungsquelle und den Zuleitungen für das Prozeßgas zusätzlich ein Abschirmgas in den Reaktorbehälter eingeleitet. Über eine Ableitung im Boden des Reaktorbehälters können die eingeleiteten Gase aus dem Inneren des Reaktorbehälters abgepumpt werden. Weitere erfindungswesentliche Merkmale sind in den Unteransprüchen gekennzeichnet.

Die Erfindung wird nachfolgend anhand von schematischen Zeichnungen näher erläutert.

Es zeigen:
- Fig. 1: Eine erfindungsgemäße Vorrichtung zur Beschichtung von Substraten,
- Fig. 2: die in der erfindungsgemäßen Vorrichtung angeordnete UV-Strahlungsquelle,
- Fig. 3: zu beschichtende Substrate innerhalb der Vorrichtung.

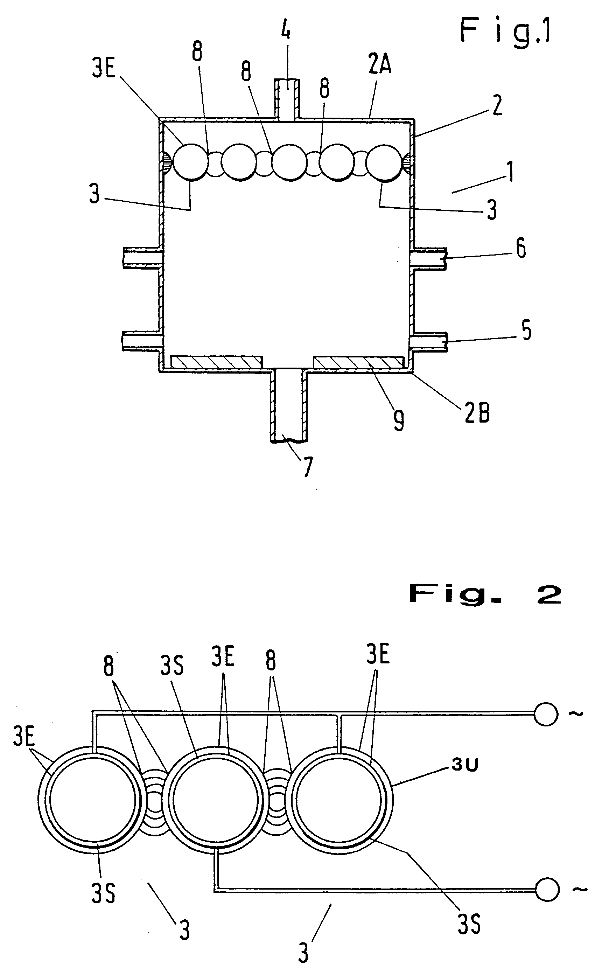

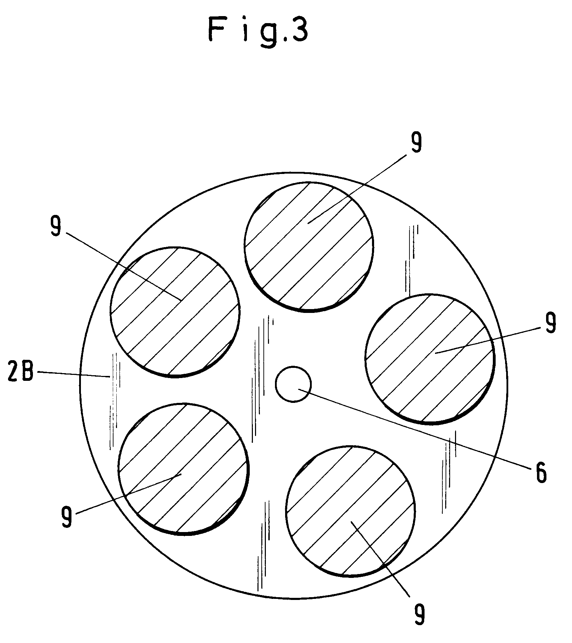

Fig. 1 zeigt die erfindungsgemäße Beschichtungsvorrichtung 1, die im wesentlichen durch einen Reaktorbehälter 2, eine UV-Strahlungsquelle 3 sowie Zuleitungen für Gase 4,5 und 6 und eine Ableitung 7 für Gase gebildet wird. Bei dem hier dargestellten Ausführungsbeispiel ist der Reaktorbehälter 2 als zylinderförmiger Körper ausgebildet, der an den Enden durch Deckflächen 2A und 2B verschlossen ist. Für die Fertigung des Reaktorbehälters 2 wird vorzugsweise ein korrosionsbeständiges Material, vorzugsweise Stahl, verwendet. Die Höhe des Reaktorbehälters beträgt etwa 30 cm. Er kann jedoch auch mit geringerer oder größerer Höhe ausgebildet werden. Der Durchmesser des Reaktorbehälters 2 beträgt bei dem hier dargestellten Ausführungsbeispiel ebenfalls 30 cm. Diese Abmessungen können selbstverständlich auch größer oder kleiner gewählt werden. Die UV-Strahlungsquelle 3 ist im Inneren des Reaktorbehälters 2 in einem Abstand von etwa 4 cm von der Deckfläche 2A des Reaktorbehälters 2 angeordnet. Die UV-Strahlungsquelle 3 wird durch mehrere Elektroden 3E gebildet. Bei dem hier dargestellten Ausführungsbeispiel sind fünf Elektroden 3E dargestellt. Erfindungsgemäß können selbstverständlich mehr oder weniger Elektroden 3E verwendet werden. Die Elektroden 3E sind als Hohlzylinder ausgebildet und aus Glas oder Metall gefertigt. In Fig. 2 ist ein Teilbereich der UV-Strahlungsquelle 3 dargestellt. Die hier gezeigten Elektroden 3E sind aus Metall gefertigt. Sie weisen auf ihrer Oberfläche 3S einen Überzug 3U aus einem Dielektrikum auf. Die Längsachsen der Elektroden 3E sind parallel in definiertem Abstand zueinander angeordnet, derart, daß zwischen zwei benachbarten Elektroden 3E jeweils ein Spalt 8 definierter Breite ausgebildet wird. Die Längsachsen der Elektroden 3E sind in einer Ebene parallel zur Deckfläche 2A angeordnet, so daß die Elektroden 3E von der Deckfläche 2A alle einen Mindestabstand von etwa 4 cm aufweisen. Die Spaltbreite zwischen je zwei benachbarten Elektroden 3E beträgt 0,1 bis 10 mm. Jeweils zwei benachbarte Elektroden sind an eine hohe Wechselspannung angeschlossen. In dem hier dargestellten Ausführungsbeispiel wird der UV-Strahlungsquelle 3 eine Leistung von 50 Watt zugeführt. In der Deckfläche 2A des Reaktorbehälters 2 ist die Zuleitung 4 für ein Gas vorgesehen. Über diese Zuleitung 4 kann bspw. Helium, Argon, Krypton oder Xenon in den Reaktorbehälter 2 eingeleitet werden. Das über die Zuleitung 4 in den Reaktorbehälter geleitete Gas wird gleichmäßig auf die Spalte 8 zwischen den Elektroden 3E verteilt. Durch das Anlegen einer hohen Wechselspannung an benachbarte Elektroden 3E wird in den Spalten 8 eine stille Entladung ausgebildet, wobei es je nach Zuleitung eines der o.g. Gase zu einer He₂-, Ar₂-, Kr₂₋ oder Xe₂-Emission kommt. Je nach verwendetem Gas kann mit Hilfe der Strahlungsquelle 3 eine UV-Strahlung mit einer Wellenlänge zwischen 90 nm und 170 nm erzeugt werden. Über Zuleitungen 5, die in den Seitenwänden des Reaktorbehälters angeordnet sind, kann ein Prozeßgas in den Reaktorbehälter 2 eingeleitet werden. Dieses Prozeßgas ist oder enthält eine gasförmige Verbindung des auf der Oberfläche eines Substrates 9 abzuscheidenden Materials. Das Substrat bzw. die Substrate 9 werden auf dem Boden 2B des Reaktorbehälters 2 angeordnet, wie es in Fig. 3 dargestellt ist. Bei dem hier gezeigten Ausführungsbeispiel sind die Substrate 9 als runde Scheiben ausgebildet. Sie können jedoch auch eine andere Form aufweisen. In der Mitte des Bodens 2B ist eine Ableitung 7 vorgesehen. Über diese können die Gase, welche in den Reaktorbehälter 2 eingeleitet wurden, abgepumpt werden. Die erfindungsgemäße Vorrichtung ist mit einer Pumpeneinrichtung (hier nicht dargestellt) versehen, die es gestattet, innerhalb des Reaktorbehälters 2 einen Druck zwischen 50 und 5000 Torr bzw. 0,0666 bis 6,666 bar aufrecht zu erhalten. Um die UV-Strahlungsquelle 3 bzw. die von ihr erzeugte UV-Strahlung vor störenden Einflüssen durch das Prozeßgas zu schützen, wird über die Zuleitungen 6, die in den Seitenwänden des Reaktorbehälters 2 angeordnet sind, ein Abschirmgas in den Reaktorbehälter 2 eingeleitet. Die Zuleitungen 6 sind etwa in halber Höhe des Reaktorbehälters 2 so angeordnet, daß eine tangentiale Einleitung des Abschirmgases in den Reaktorbehälter 2 möglich ist. Die Beschichtung mehrerer scheibenförmiger Substrate 9, die auf dem Boden 2B des Reaktorbehälters 2 angeordnet sind, werden nachfolgend beschrieben.

Die Substrate 9 können aus einem organischen oder anorganischen Werkstoff bestehen. Die zu beschichtenden Oberflächen der Substrate 9 werden so angeordnet, daß sie der UV-Strahlungsquelle 3 unmittelbar gegenüberliegen. Bei dem hier dargestellten Ausführungsbeispiel sollen die Substrate 9 mit einer siliziumhaltigen Schicht, bspw. Siliziumdioxid oder Siliziumnitrid beschichtet werden. Als Beschichtungsmaterial wird gasförmiges SiH₄ verwendet. Dieses adsorbiert erst unterhalb von 150 nm. Zur Durchführung der photolytischen Spaltung ist deshalb die Verwendung einer UV-Strahlung mit einer Wellenlänge zwischen 120 und 135 nm sinnvoll, da sich diese praktisch mit der maximalen Absorption von SiH₄ deckt. zu diesem Zweck wird über die Zuleitung 4 Argon in die Spalte 8 zwischen den Elektroden 3 geleitet. Die Elektroden 3 werden hierzu, wie oben beschrieben,an eine hohe Wechselspannung angeschlossen. Durch das Hindurchströmen des Argons durch die Spalte 8 wird eine intensive VUV-Strahlung erzeugt, deren Maximum bei etwa 128 nm liegt und die eine Halbwertsbreite von ca. 10 nm aufweist. Mit Hilfe dieser UV-Strahlung ist eine photolytische Spaltung des über die Zuleitungen 5 in den Reaktorbehälter 2 eingeleiteten Prozeßgases möglich. Das Prozeßgas ist bei dem hier dargestellten Ausführungsbeispiel in einem Trägergas, bspw. Argon, enthalten, und wird durch die spezielle Anordnung der Zuleitungen 5 über die Oberflächen der Substrate 9 geleitet, so daß eine Abscheidung einer siliziumhaltigen Schicht möglich ist. Soll eine Schicht in Form von Siliziumdioxid oder Siliziumnitrid abgeschieden werden, so werden dem Prozeßgas zusätzliche Anteile an Sauerstoff oder Stickstoff beigemengt. Über die Zuleitung 4 können anstelle von Argon auch Helium, Krypton oder Xenon eingeleitet werden, wenn bspw. für die Abscheidung eines anderen Beschichtungsmaterials UV-Strahlung mit einer anderen Wellenlänge zwischen 90 nm und 170 nm erforderlich ist, um die photolytische Spaltung durchzuführen. Der erfindungsgemäße Reaktorbehälter 2 kann zur Beschichtung von Substraten 9 auch dann verwendet werden, wenn das Beschichtungsmaterial nicht gasförmig in den Reaktorbehälter 2 eingeleitet wird, sondern aus einer Lösung oder in Form eines Pulvers direkt auf die Oberfläche der Substrate aufgetragen und dann mittels UV-Strahlung zersetzt wird.

## Patentansprüche

1. Vorrichtung mit einer UV-Strahlungsquelle (3) und wenigstens einer Zuleitung (5) für ein Prozeßgas (5) zur Beschichtung eines Substrates (9) mit einem Überzug, dadurch gekennzeichnet, daß ein Reaktorbehälter (2) vorgesehen ist, in dem die UV-Strahlungsquelle (3) und das zu beschichtende Substrat (9) gemeinsam angeordnet sind, wobei die Zuleitung (5) für das Prozeßgas tangential zur Oberfläche des Substrates (9) im Abstand von wenigstens 2 cm hiervon angeordnet ist, und daß wenigstens eine Zuleitung (6) für ein Abschirmgas zwischen der UV-Strahlungsquelle (3) und der Zuleitung (5) für das Prozeßgas vorgesehen ist, sowie mindestens eine Ableitung (7) für die in den Reaktorbehälter (2) eingeleiteten Gase vorgesehen sind.

2. Vorrichtung nach Anspruch 1, dadurch gekennzeichnet, daß die UV-Strahlungsquelle (3) aus Elektroden (3E) besteht, die als langgestreckte Hohlkörper ausgebildet sind, deren Längsachsen parallel zueinander und in definiertem Abstand voneinander angeordnet sind, und daß die Elektroden (3E) in einer Ebene parallel zur Deckfläche (2A) des Reaktorbehälters (2) angeordnet sind.

3. Vorrichtung nach Anspruch 2, dadurch gekennzeichnet, daß zwischen je zwei benachbarten Elektroden (3E) ein Spalt (8) mit einer Breite zwischen 0,1 und 10 mm ausgebildet ist, und daß je zwei benachbarte Elektroden (3E) zur Ausbildung einer stillen Entladung in dem zwischen ihnen angeordneten Spalt (8) an eine hohe Wechselspannung angeschlossen sind, so daß der UV-Strahlungsquelle (3) eine Leistung von 50 Watt zugeführt wird.

4. Vorrichtung nach Anspruch 2 oder 3, dadurch gekennzeichnet, daß die Elektroden (3E) als Hohlzylinder ausgebildet und aus Glas oder Metall gefertigt sind, daß die aus Glas gefertigten Elektroden (3E) innen eine metallische Beschichtung aufweisen, und daß die aus Metall gefertigten Elektroden (3E) außen einen Überzug (3U) aus einem Dielektrikum aufweisen.

5. Vorrichtung nach einem der Ansprüche 1 bis 4, dadurch gekennzeichnet, daß in der Deckfläche (2A) des Reaktorbehälters (2) die Zuleitung (4) für das eine Ar₂-, Kr₂- oder XE₂-Emission bewirkende Gas angeordnet ist, und daß dieses Gas hierfür in die Spalte (8) zwischen den Elektroden (3E) einleitbar ist.

6. Vorrichtung nach einem der Ansprüche 1 bis 5, dadurch gekennzeichnet, daß der Reaktorbehälter (2) alsQuader oder Zylinder mit einer Deckfläche (2A) und einem Boden (2B) ausgebildet ist, daß die Zuleitungen (4) für das die Emikssion bewirkende Gas an der Deckfläche (2A) und die Elektroden (3E) der UV-Strahlungsquelle (3) im Abstand von etwa 4 cm hiervon angeordnet sind, daß das zu beschichtende Substrat (9) auf dem Boden (2B) des Reaktorbehälters (2) angeordnet ist und daß die Zuleitungen (5) für das Prozeßgas in den Seitenwänden des Reaktorbehälters (2) im Abstand von wenigstens 2 cm von der Oberfläche des Substrats (9) installiert sind, und daß die zuleitungen (6) für das Abschirmgas mittig in den Seitenwänden des Reaktorbehälters (2) angeordnet sind, und daß die Ableitung (7) für das in den Reaktorbehälter (2) eingeleitete Gas mittig im Boden (2B) installiert und das Gas über eine Pumpe absaugbar sind.

7. Vorrichtung nach einem der Ansprüche 1 bis 6, dadurch gekennzeichnet, daß der Reaktorbehälter (2) aus einem korrosionsbeständigen Werkstoff, vorzugsweise Stahl, gefertigt ist.

## Claims

1. A device with a UV-radiation source (3) and with at least one supply line (5) for a process gas (5) to coat a substrate (9) with a coating, characterised in that a reactor vessel (2) is provided, in which the UV-radiation source (3) and the substrate (9) which is to be coated are arranged together, in which the supply line (5) for the process gas is arranged tangentially to the surface of the substrate (9) at a distance of at least 2 cm therefrom, and that at least one supply line (6) is provided for a screening gas between the UV-radiation source (3) and the supply line (5) for the process gas, and also at least one outlet line (7) is provided for the gases which are introduced into the reactor vessel (2).

2. A device according to Claim 1, characterised in that the UV-radiation source (3) consists of electrodes (3E), which are constructed as elongated hollow bodies, the longitudinal axes of which are arranged parallel to each other and at a defined distance from each other, and that the electrodes (3E) are arranged in a plane parallel to the cover surface (2A) of the reactor vessel (2).

3. A device according to Claim 2, characterised in that a gap (8) with a width of between 0.1 and 10 mm is formed between each two adjacent electrodes (3E), and that each two adjacent electrodes (3E) are connected to a high alternating voltage to form a silent discharge in the gap (8) which is arranged between them, so that a power of 50 Watts is supplied to the UV-radiation source (3).

4. A device according to Claim 2 or 3, characterised in that the electrodes (3E) are constructed as a hollow cylinder and are produced from glass or metal, that the electrodes (3E) produced from glass have internally a metallic coating, and that the electrodes (3E) produced from metal have externally a coating (3U) of a dielectric.

5. A device according to one of Claims 1 to 4, characterised in that in the cover surface (2A) of the reactor vessel (2) the supply line (4) is arranged for the gas bringing about an Ar₂-, Kr₂- or XE₂-emission, and that this gas is able to be introduced for this into the gaps (8) between the electrodes (3E).

6. A device according to one of Claims 1 to 5, characterised in that the reactor vessel (2) is constructed as a parallelepiped block or a cylinder with a cover surface (2A) and a base (2B), that the supply lines (4) for the gas bringing about the emission are arranged on the cover surface (2A) and the electrodes (3E) of the UV-radiation source (3) are arranged at a distance of approximately 4 cm therefrom, that the substrate (9) which is to be coated is arranged on the base (2B) of the reactor vessel (2) and that the supply lines (5) for the process gas are installed in the side walls of the reactor vessel (2) at a distance of at least 2 cm from the surface of the substrate (9), and that the supply lines (6) for the screening gas are arranged centrally in the side walls of the reactor vessel (2), and that the outlet line (7) for the gas which is introduced into the reactor vessel (2) is installed centrally in the base (2B) and the gas is able to be sucked out by means of a pump.

7. A device according to one of Claims 1 to 6, characterised in that the reactor vessel (2) is produced from a corrosion-resistant material, preferably steel.

## Revendications

1. Dispositif muni d'une source de rayonnement UV (3) et au moins d'une conduite d'alimentation (5) pour un gaz de procédé (5) pour un revêtement d'un substrat (9) avec une couche de revêtement, caractérisé en ce qu'on prévoit un récipient de réacteur (2), dans lequel sont disposés ensemble la source de rayonnement UV (3) et le substrat à recouvrir (9), la conduite d'alimentation (5) pour le gaz de procédé étant disposée de manière tangentielle à la surface du substrat (9) à une distance d'au moins 2 cm de celle-ci et en ce qu'est prévue au moins une conduite d'alimentation (6) pour un gaz de protection entre la source de rayonnement UV (3) et la conduite d'alimentation (5) pour le gaz de procédé, ainsi qu'est prévue au moins une conduite de dérivation (7) pour les gaz introduits dans le récipient de réacteur (2).

2. Dispositif selon la revendication 1, caractérisé en ce que la source de rayonnement UV (3) est constituée d'électrodes (3E) qui sont formées comme des corps creux allongés dont les axes longitudinaux sont disposés de manière parallèle les uns par rapport aux autres et selon une distance définie les uns des autres et en ce que les électrodes (3E) sont disposées dans un plan parallèle à la surface de fermeture (2A) du récipient de réacteur (2).

3. Dispositif selon la revendication 2, caractérisé en ce qu'est formé entre à chaque fois deux électrodes voisines (3E) un interstice (8) avec une largeur entre 0,1 et 10 mm et en ce qu'à chaque fois deux électrodes voisines (3E) sont raccordées à une tension alternative élevée pour la formation d'une décharge silencieuse dans l'interstice (8) disposé entre elles, de sorte qu'on apporte à la source de rayonnement UV (3) une puissance de 50 W.

4. Dispositif selon la revendication 2 ou 3, caractérisé en ce que les électrodes (3E) sont formées comme un cylindre creux et sont fabriquées à partir de verte ou de métal, en ce que les électrodes (3E) fabriquées à partir de verte présentent à l'intérieur un revêtement métallique et en ce que les électrodes (3E) fabriquées à partir de métal présentent à l'extérieur une couche de revêtement (3U) constituée d'un diélectrique.

5. Dispositif selon l'une quelconque des revendications 1 à 4, caractérisé en ce que dans la surface de fermeture (2A) du récipient de réacteur (2) est disposée la conduite d'alimentation (4) pour le gaz produisant une émission Ar₂, Kr₂ ou Xe₂ et en ce que ce gaz peut être introduit pour cela dans les interstices (8) entre les électrodes (3E).

6. Dispositif selon l'une quelconque des revendications 1 à 5, caractérisé en ce que le récipient de réacteur (2) est formé comme un cube ou un cylindre avec une surface de fermeture (2A) et un fond (2B), en ce que les conduites d'alimentation (4) pour le gaz produisant l'émission sont disposées sur la surface de fermeture (2A) et les électrodes (3E) de la source de rayonnement UV (3) à une distance d'environ 4 cm de celles-ci, en ce que le substrat (9) à recouvrir est disposé sur le fond (2B) du récipient de réacteur (2) et en ce que les conduites d'alimentation (5) pour le gaz de procédé sont installées sur les parois latérales du récipient de réacteur (2) à une distance d'au moins 2 cm de la surface du substrat (9) et en ce que les conduites d'alimentation (6) pour le gaz de protection sont disposées au milieu dans les parois latérales du récipient de réacteur (2) et en ce que la conduite de dérivation (7) pour le gaz introduit dans le récipient de réacteur (2) est installée au milieu dans le fond (2B) et le gaz peut être aspiré par l'intermédiaire d'une pompe.

7. Dispositif selon l'une quelconque des revendications 1 à 6, caractérisé en ce que le récipient de réacteur (2) est fabriqué à partir d'une matière première résistante à la corrosion, de préférence en acier.
